# EUROPEAN PATENT APPLICATION

(11) **EP 4 439 180 A1**
(43) Date of publication of application: **02.10.2024**
(21) Application number: 23165896.4
(22) Date of filing: 31.03.2023
(51) Int. Cl.: G03F 9/00

(54) **A METHOD FOR MODELING METROLOGY DATA OVER A SUBSTRATE AREA AND ASSOCIATED APPARATUSES**

(71) Applicant: ASML Netherlands B.V., 5500 AH Veldhoven (NL)
(72) Inventor: BRINKHOF, Ralph, 5500 AH Veldhoven (NL); HINTERDING, Stijn Oskar Matisse, 5500 AH Veldhoven (NL); VAN DER HEIJDEN, Thijs, Willem, Gerrit, 5500 AH Veldhoven (NL)
(74) Representative: ASML Netherlands B.V.

(57) **Abstract**

Disclosed is method for modeling metrology data over a substrate area relating to a substrate in a lithographic process. The method comprises obtaining first layer model data, said first layer model data relating to a first model fitted to first layer metrology data for exposure of a first layer on said substrate and second layer metrology data relating to a second layer on said substrate, said second layer being exposed subsequent to exposure of said first layer. Metrology content is subtracted from the second layer metrology data. A second model is fitted to said corrected second layer metrology data or a component thereof, said second model being different to said first model and an output model is determined from at least said second model, said output model being corrected for a model mismatch resultant from said first model and said second model.

## Description

### FIELD

The present disclosure relates to processing of substrates for the production of, for example, semiconductor devices.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use radiation. The wavelength of this radiation determines the minimum size of features which can be formed on the substrate. Typical wavelengths currently in use are about 365 nm (i-line), about 248 nm, about 193 nm and about 13 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of about 193 nm.

Low-k1 lithography may be used to process features with dimensions smaller than the classical resolution limit of a lithographic apparatus. In such a process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of a numerical aperture (NA,) a customized illumination scheme, use of one or more phase shifting patterning devices, optimization of the design layout such as optical proximity correction (OPC) in the design layout, or other methods generally defined as resolution enhancement techniques (RET). Additionally or alternatively, one or more tight control loops for controlling a stability of the lithographic apparatus may be used to improve reproduction of the pattern at low k1.

Effectiveness of the control of a lithographic apparatus may depend on characteristics of individual substrates. For example, a first substrate processed by a first processing tool prior to processing by the lithographic apparatus (or any other process step of the manufacturing process, herein referred to generically as a manufacturing process step) may benefit from (slightly) different control parameters than a second substrate processed by a second processing tool prior to processing by the lithographic apparatus.

The accurate placement of patterns on the substrate is a chief challenge for reducing the size of circuit components and other products that may be produced by lithography. In particular, the challenge of measuring accurately the features on a substrate which have already been laid down is a critical step in being able to align successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself. Not all distortions are correctable during exposure, however, and it remains important to trace and eliminate as many causes of such distortions as possible.

These distortions of the wafer grid are represented by metrology data associated with mark position. The metrology data are obtained from measurements of wafers. An example of such measurements are alignment measurements of alignment marks performed using an alignment system in a lithographic apparatus prior to exposure.

It is sometimes desirable to use a different modeling strategy (e.g., different models) for different layers of the same substrate. However, doing this may introduce errors due solely to the different modeling strategies used.

It is therefore desirable to adapt the alignment modeling approach, to counteract errors introduced by the use of different modeling strategies in different layers.

### SUMMARY

In a first aspect of the invention there is provided a method for modeling metrology data over a substrate area relating to a substrate in a lithographic process, comprising: obtaining first layer model data, said first layer model data relating to a first model fitted to first layer metrology data for exposure of a first layer on said substrate; obtaining second layer metrology data relating to a second layer on said substrate, said second layer being exposed subsequent to exposure of said first layer; subtracting metrology content from said second layer metrology data, said metrology content being obtained from said first layer model data or a component thereof and/or said first layer metrology data to obtain corrected second layer metrology data; fitting a second model to said corrected second layer metrology data or a component thereof, said second model being different to said first model; and determining an output model from at least said second model, said output model being corrected for a model mismatch resultant from said first model and said second model.

In a further aspect of the invention, there is provided a computer program comprising program instructions operable to perform the method of the first aspect when run on a suitable apparatus, and associated processing apparatus and lithographic apparatus.

### BRIEF DESCRIPTION OF THE DRAWINGS

Embodiments of the invention will now be described, by way of example only, with reference to the accompanying schematic drawings, in which:
Figure 1 depicts a schematic overview of a lithographic apparatus;
Figure 2 depicts a schematic overview of a lithographic cell;
Figure 3 shows schematically the use of the lithographic apparatus and lithographic cell of Figures 1 and 2 together with one or more other apparatuses forming a manufacturing facility for, e.g., semiconductor devices, the facility implementing a control strategy according to an embodiment of the invention;
Figure 4 is a 1D illustration of the concept of model content mismatch, showing (a) an example where there is no model content mismatch and (b) an example where there is model content mismatch;
Figure 5 is a 1D illustration of the concept of model interpolation mismatch;
Figure 6 is a flow diagram of a method according to a first embodiment;
Figure 7 is a flow diagram of a method according to a second embodiment
Figure 8 is a flow diagram of a method according to a third embodiment
Figure 9 is a flow diagram of a method according to a fourth embodiment; and
Figure 10 is a flow diagram of a method according to a fifth embodiment.

### DETAILED DESCRIPTION

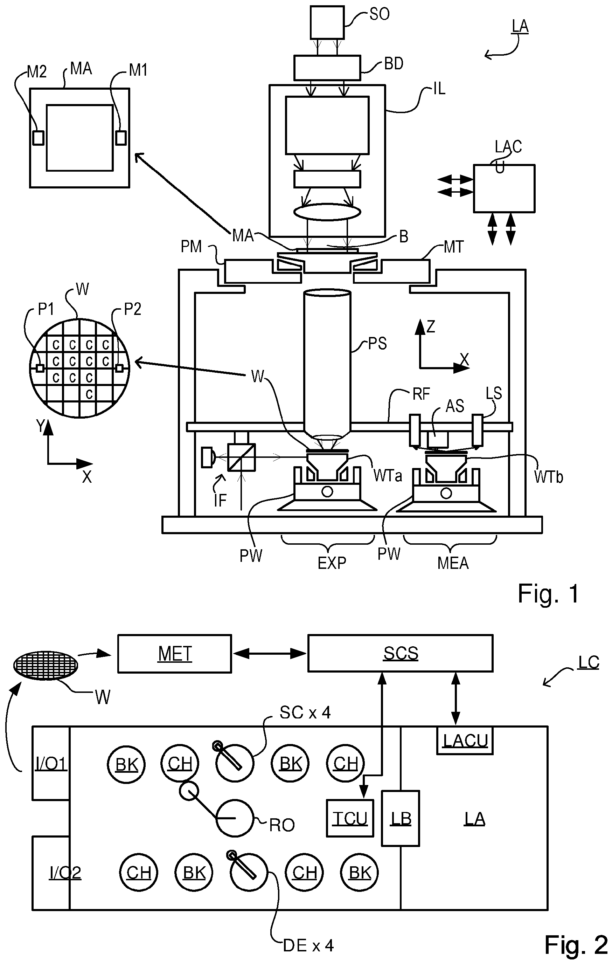

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support (e.g., a mask table) T constructed to support a patterning device (e.g., a mask) MA and connected to a first positioner PM configured to accurately position the patterning device MA in accordance with certain parameters, one or more substrate supports (e.g., a wafer table) WTa and WTb constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in U.S. Patent No. 6,952,253, which is incorporated herein by reference.

Lithographic apparatus LA in this example is of a so-called dual stage type which has two substrate tables WTa and WTb and two stations - an exposure station and a measurement station-between which the substrate tables can be moved. While one substrate on one substrate table is being exposed at the exposure station EXP, another substrate can be loaded onto the other substrate table at, e.g., the measurement station MEA or at another location (not shown) or can be processed at measurement station MEA. A substrate table with a substrate can be located at measurement station MEA so that various preparatory steps may be carried out. The preparatory steps may include mapping the surface height of the substrate using a level sensor LS and/or measuring the position of alignment marks on the substrate using an alignment sensor AS. Due to inaccuracies in creating the marks and also due to deformations of the substrate that occur throughout its processing, the set of marks may next to translation and rotation have undergone more complex transformations. Consequently, in addition to measuring position and orientation of the substrate, the alignment sensor in practice may measure in detail the positions of many marks across the substrate area, if the apparatus LA is to print product features at the correct locations with high accuracy. The measurement of alignment marks can therefore be time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. An embodiment of the invention can be applied in an apparatus with only one substrate table, or with more than two.

In addition to having one or more substrate supports, the lithographic apparatus LA may comprise a measurement stage (not shown). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The apparatus further includes a lithographic apparatus control unit LACU which controls all the movements and measurements of various actuators and sensors of the lithographic apparatus (such as those described). Control unit LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

As shown in Figure 2 the lithographic apparatus LA may form part of a lithographic cell LC, also sometimes referred to as a lithocell or (litho)cluster, which often also includes apparatuses to perform pre- and post-exposure processes on a substrate W. Conventionally these apparatuses includes one or more spin coaters SC to deposit resist layers, one or more developers DE to develop exposed resist, one or more chill plates CH and one or more bake plates BK, e.g. for conditioning the temperature of substrates W e.g. for conditioning solvents in the resist layers. A substrate handler, or robot, RO picks up substrates W from input/output ports I/O1, I/O2, moves them between the different processing apparatuses and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, one or more inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus MET, which may also be referred to as a metrology apparatus or metrology tool, is used to determine one or more properties of the substrates W, and in particular, how one or more properties of different substrates W vary or how one or more properties associated with different layers of the same substrate W vary from layer to layer. The inspection apparatus may be constructed to identify defects on the substrate W and may, for example, be part of the lithocell LC, or may be integrated into the lithographic apparatus LA, or may even be a stand-alone device. The inspection apparatus may measure the one or more properties on a latent image (an image in a resist layer after the exposure), or on a semi-latent image (an image in a resist layer after a post-exposure bake step), or on a developed resist image (in which the exposed or unexposed parts of the resist have been removed), or even on an etched image (after a pattern transfer step such as etching).

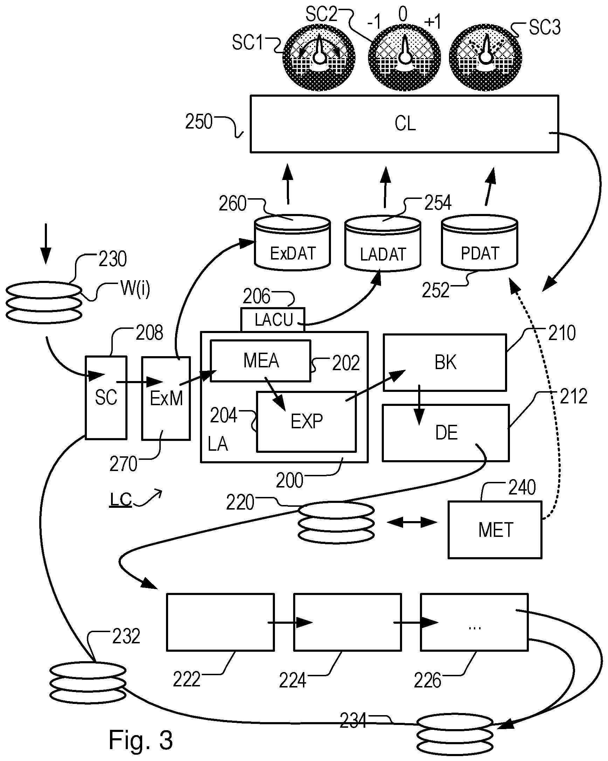

Figure 3 shows the lithographic apparatus LA and the lithocell LC in the context of an industrial manufacturing facility for, e.g., semiconductor products. Within the lithographic apparatus (or "litho tool" 200 for short), the measurement station MEA is shown at 202 and the exposure station EXP is shown at 204. The control unit LACU is shown at 206. As already described, litho tool 200 forms part of a "litho cell" or "litho cluster" that also includes a coating apparatus SC, 208 for applying photosensitive resist and/or one or more other coatings to substrate W for patterning by the apparatus 200. At the output side of apparatus 200, a baking apparatus BK, 210 and developing apparatus DE, 212 are provided for developing the exposed pattern into a physical resist pattern. Other components shown in Figure 3 are omitted, for clarity.

Once the pattern has been applied and developed, patterned substrates 220 are transferred to other processing apparatuses such as are illustrated at 222, 224, 226. A wide range of processing steps are implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses.

The described semiconductor manufacturing process comprising a sequence of patterning process steps is just one example of an industrial process in which the techniques disclosed herein may be applied. The semiconductor manufacturing process includes a series of patterning steps. Each patterning process step includes a patterning operation, for example a lithographic patterning operation, and a number of other chemical and/or physical operations.

The manufacture of semiconductor devices involves many repetitions of such processing, to build up device structures with appropriate materials and patterns, layer-by-layer on the substrate. Modern device manufacturing processes may comprise 40 or 50 individual patterning steps, for example. Accordingly, substrates 230 arriving at the litho cluster may be newly prepared substrates, or they may be substrates that have been processed previously in this cluster 232 or in another apparatus entirely. Similarly, depending on the required processing, substrates on leaving apparatus 226 may be returned for a subsequent patterning operation in the same litho cluster (such as substrates 232), they may be destined for patterning operations in a different cluster (such as substrates 234), or they may be finished products to be sent for dicing and packaging (such as substrates 234).

Each layer of the product structure typically involves a different set of process steps, and the apparatuses used at each layer may be completely different in type. Further, even where the processing steps to be applied by the apparatuses are nominally the same, in a large facility, there may be several supposedly identical machines working in parallel to perform the processing on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. Parallel processing may also be performed in different chambers within a larger apparatus. Moreover, in practice, different layers often involve different etch processes, for example chemical etch, plasma etch, etc., according to the details of the material to be etched, and special requirements such as, for example, anisotropic etching.

The previous and/or subsequent processes may be performed in other lithography apparatuses, as just mentioned, and may even be performed in different types of lithography apparatus. For example, one or more layers in the device manufacturing process which are very demanding in terms of, e.g., resolution and/or overlay may be performed in a more advanced lithography tool than one or more other layers that are less demanding. Therefore, one or more layers may be exposed in an immersion type lithography tool, while one or more others are exposed in a 'dry' tool. One or more layers may be exposed in a tool working at DUV wavelengths, while one or more others are exposed using EUV wavelength radiation.

Also shown in Figure 3 is the metrology apparatus (MET) 240 which is provided for making measurements of parameters of the products at desired stages in the manufacturing process. A common example of a metrology station in a modern lithographic manufacturing facility is a scatterometer, for example an angle-resolved scatterometer or a spectroscopic scatterometer, and it may be applied to measure one or more properties of developed substrates at 220 prior to etching in the apparatus 222. Using metrology apparatus 240, performance parameter data PDAT 252 may be determined. From this performance parameter data PDAT 252, it may be further determined that a performance parameter, such as overlay or critical dimension (CD), does not meet specified accuracy requirements in the developed resist. Prior to the etching step, the opportunity exists to strip the developed resist and reprocess one or more of the substrates 220 through the litho cluster. Moreover, the metrology results from the metrology apparatus 240 can be used to maintain accurate performance of the patterning operations in the litho cluster, by making small adjustments over time, thereby reducing or minimizing the risk of products being made out-of-specification, and requiring re-work. Of course, metrology apparatus 240 and/or one or more other metrology apparatuses (not shown) can be applied to measure one or more properties of the processed substrates 232, 234, and/or of incoming substrates 230.

Typically the patterning process in a lithographic apparatus LA is one of the most significant steps in the processing which involves high accuracy of dimensioning and placement of structures on the substrate W. To help ensure this high accuracy, three systems may be combined in a control environment as schematically depicted in Figure 3. One of these systems is the litho tool 200 which is (virtually) connected to a metrology apparatus 240 (a second system) and to a computer system CL 250 (a third system). A desire of such an environment is to optimize or improve the cooperation between these three systems to enhance an overall so-called "process window" and provide one or more tight control loops to help ensure that the patterning performed by the lithographic apparatus LA stays within a process window. The process window defines a range of values of a plurality of process parameters (e.g. two or more selected from dose, focus, overlay, etc.) within which a specific manufacturing process yields a defined result (e.g. a functional semiconductor device) - typically a range within which the values of the process parameters in the lithographic process or patterning process are allowed to vary while yielding a proper structure (e.g., specified in terms of an acceptable range of CD (such as +- 10% of a nominal CD)).

The computer system CL may use (part of) the design layout to be patterned to predict which one or more resolution enhancement techniques to use and to perform computational lithography simulations and calculations to determine which patterning device layout and lithographic apparatus settings achieve a largest overall process window of the patterning process (depicted in Figure 3 by the double arrow in the first dial SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second dial SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third dial SC3).

Computer system 250 can implement control of the process based on a combination of (i) "pre-processing metrology data" (e.g., including scanner metrology data LADAT 254, and External pre-processing metrology ExDAT 260), associated with substrates before they are processed in a given processing step (for example a lithography step) and (ii) performance data or "post-processing data" PDAT 252 that is associated with the substrates after they have been processed.

A first set of pre-processing metrology data LADAT 254 (referred to herein as scanner metrology data, as it is data generated by the lithographic apparatus LA 200 or scanner) may comprise the alignment data conventionally obtained by the lithographic apparatus LA 200 using alignment sensor AS in the measurement station 202. Alternatively, or in addition to the alignment data, the scanner metrology data LADAT 254 may include height data obtained using level sensor LS, and/or "wafer quality" signals from the alignment sensor AS or the like. As such, the scanner metrology data LADAT 254 may comprise an alignment grid for the substrate, and data relating to substrate deformation (flatness). For example, the scanner metrology data LADAT 254 may be generated by the measurement station MEA 202 of twin stage lithographic apparatus LA 200 (e.g., as this typically comprises the alignment sensor and leveling sensor) in advance of exposure, enabling simultaneous measurement and exposure operations. Such twin stage lithographic apparatus are well known.

Increasingly, (e.g. stand-alone) external pre-exposure metrology tools ExM 270 are used to make measurements before exposure on a lithographic apparatus. Such external pre-exposure metrology tools ExM 270 are distinct from the measurement station MEA 202 of a twin stage lithographic apparatus LA 200. Any pre-exposure measurements performed within the track are also considered to be external measurements. To maintain exposure throughput at a sufficient level, the scanner metrology data LADAT (e.g., alignment grid and substrate deformation grid) measured by measurement station MEA 202 is based on a sparser set of measurements as would be desirable. This typically means such a measurement station is incapable of gathering sufficient metrology data for higher order corrections, and particularly corrections beyond the third order. In addition to this, use of an opaque hard mask can make it difficult to accurately measure the wafer grid in alignment.

External pre-exposure metrology tools ExM 270 enable much denser measurements to be made on each substrate, prior to exposure. Some of these pre-exposure metrology tools ExM 270 measure and/or predict wafer grid deformation at a throughput equal to or faster than the scanner, and with a measurement density much higher than can be achieved using an alignment sensor and level sensor, even when such sensors are comprised within a separate measurement station MEA 202. Pre-exposure metrology tools comprise, for example, substrate shape inspection tools and/or stand-alone alignment stations.

While Figure 3 shows separate storage 252, 254, 260 for each of the performance data PDAT, scanner metrology data LADAT and external pre-exposure data ExDAT, it will be appreciated that these different types of data may be stored in one common storage unit, or may be distributed over a larger number of storage units, from which particular items of data can be retrieved when required.

To represent alignment measurements over a wafer and/or over a field, an alignment model is used. A first purpose of an alignment model is to provide a mechanism for interpolating and/or extrapolating the available measurements data over the whole wafer, such that an expose grid can be created on each exposure field. The metrology data will be sparse as it is simply not practical to measure as many measurement regions as would be desirable from an overlay accuracy perspective: the time and therefore throughput overhead would be too high. A second purpose of an alignment model is to provide noise suppression. This may be achieved by using fewer model parameters than measurements or by using regularization.

While standard models (e.g., linear models) might use fewer than ten parameters (e.g., 6 parameters), advanced or higher order alignment models may use more than 10 parameters, more than 15 parameters, or more than 30 parameters. Examples of advanced models are higher order wafer alignment (HOWA) models and radial basis function (RBF) based alignment models. HOWA is a published technique based on second and higher order polynomial functions. The order number may vary, e.g., it may be second order or higher, third order or higher, fourth order or higher, fifth order or higher etc.. RBF modeling is described in US2012218533A1, which is incorporated herein by reference. Different versions and extensions of these advanced models can be devised (e.g., different modeling orders for HOWA or different regularization for RBF). The advanced models generate a complex description of the wafer grid that is corrected for, during the exposure of the target layer. RBF and latest versions of HOWA provide particularly complex descriptions based on tens of parameters. This implies many measurements are required to obtain a wafer grid with sufficient accuracy.

In recent years, the demand for and use of high-order (e.g., of increasingly higher orders) or more 'local' models has increased. It can be shown that a significant overlay benefit can be gained when the wafer alignment modeling strategy uses a higher order and/or more local model (i.e., a higher content capture model capable of capturing more content from a dataset). However, this overlay benefit is typically only seen with respect to the layers below. The overlay with respect to the layers above may actually deteriorate as a result of this alignment model switch.

It may be impossible or impractical to adhere to the same alignment model through the whole product stack; sometimes it is necessary to switch the wafer model type or model order between product layers. There may be several reasons for this, for example:
- The model order or mark layout are not supported by the current lithographic apparatus (or scanner);
- The exposure settings do not allow for sufficient marks to be measured in a throughput-neutral manner;
- The mark measurements are too noisy for a high-order model to be feasible.

However, switching the alignment model results in a so-called layer-to-layer model content mismatch: the alignment models give a different description of the wafer deformation. The result of this is that the overlay may be impacted. More specifically, this model content mismatch may result in an overlay impact which is additional to overlay resultant from "actual" positional errors (e.g., imaging and positional errors).

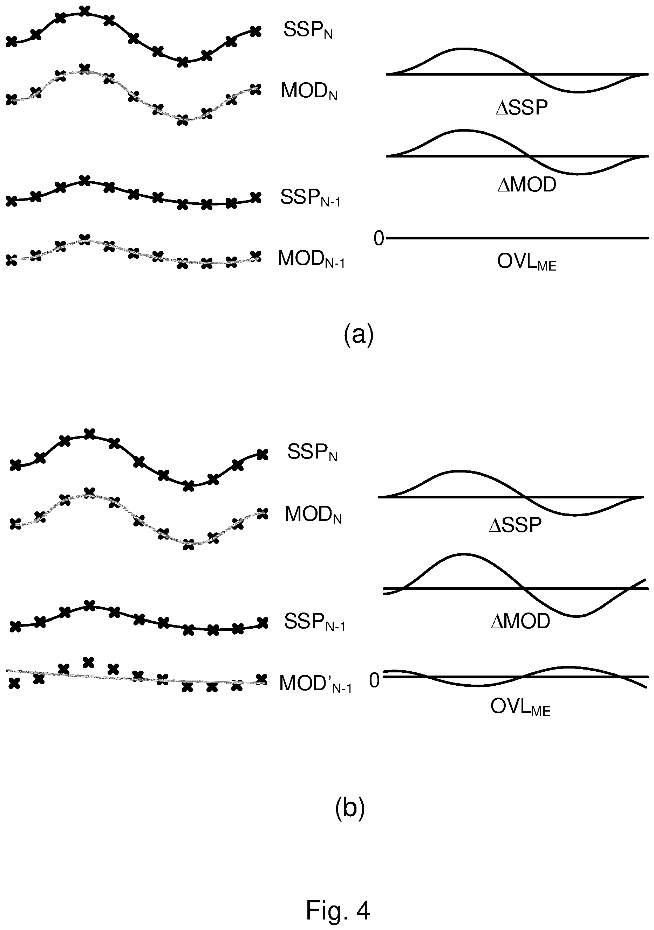

The concept of model content mismatch will be explained in combination with Figure 4. An alignment model, when fitted to the alignment data, describes a shape of a substrate grid (e.g. in terms of aligned position deviation APD with respect to a nominal grid). For every exposed layer, alignment marks (having been exposed in a preceding layer) are measured to obtain metrology or alignment data for that layer, and an alignment model is fitted to that metrology data. Each layer exposure is then positioned with reference to the respective substrate grid as described by a respective fitted alignment model for that layer. This enables changes in substrate shape to be modeled and tracked for each layer. Consider a hypothetical example where there is absolutely no change in the substrate shape between a layer N-1 and subsequent layer N, but where a different model is fitted to the alignment data for each of these layers. In this case, differences in the fitted model will typically result in a change in the alignment grid used for exposure of each of these two layers, despite there being no change in the substrate shape between these exposures. This grid change results solely from the model change rather than any physical change and will result in an exposure positional error between the layers, i.e., overlay; this is model content mismatch.

Figure 4 illustrates this in a 1-dimensional example (of course, actual alignment models are typically two dimensional in the substrate plane). Figure 4(a) shows a first example where the same model strategy (a model of the same order and basis) is fitted to the first layer N and second layer N-1. The measured data (alignment data) is represented by a 1D array of crosses. The same dataset is shown twice per layer: with the actual substrate shape plotted SSP_{N-1}, SSP_{N} (black line) and with an exemplary fitted alignment model plotted MOD_{N-1}, MOD_{N} (gray line). To the right of these datasets is a plot (over the same substrate distance) of the change in (actual) substrate shape ΔSSP between layer N-1 and layer N and the corresponding change in modeled shape ΔMOD. A third plot OVL_{ME} is a difference of the plots ΔSSP and ΔMOD; this is the overlay impact due to model content mismatch error. Because the same model has been used (and assuming a perfect case), the overlay impact due to model error OVL_{ME} is zero in Figure 4(a).

Figure 4(b) shows a second example where a different model strategy is used for a first layer N and second layer N-1. More specifically, a lower order model (or more generally a lower content capture model) MOD'_{N-1} is fitted to the alignment data for layer N-1 than the model MOD_{N} fitted to the alignment data for layer N. In this example, the actual substrate shapes SSP_{N-1}, SSP_{N}, and therefore the change in substrate shape ΔSSP, are the same as in Figure 4(a). However, the change in the fitted model ΔMOD is now different, resulting in a non-zero overlay impact due to model error OVL_{ME}.

Note that model content mismatch may also result from using different sets of hyper-parameters, e.g. regulation strategies, to an (e.g., RBF) model applied to the each layer.

A separate but similar issue which may arise when different modeling strategies are used in different layers may be referred to as model interpolation mismatch. This issue is specific to the situation where the models used for the two different layers use a different basis set, e.g., a polynomial model is used for a first layer and a radial base function (RBF) model used for a second layer, even though they otherwise are able to capture the same alignment content. When models of a different basis are also unable to capture the same alignment content, then model content mismatch may occur in addition to the model interpolation mismatch. This issue of model interpolation mismatch can occur for both direct and indirect alignment.

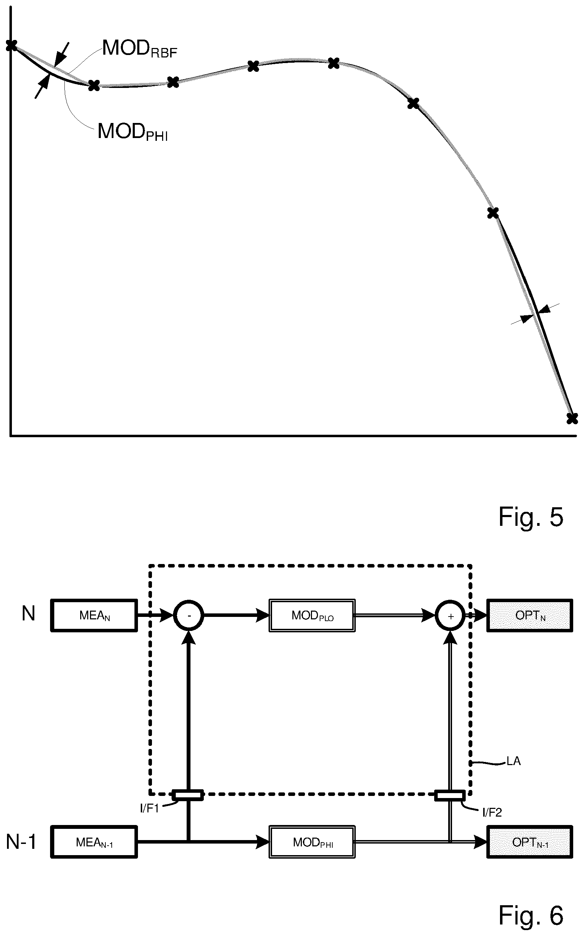

Figure 5 is a 1D plot of alignment position deviation APD (i.e., grid position with respect to a nominal grid) position against x-position which illustrates model interpolation mismatch. The crosses comprise the metrology dataset containing up to 5^{th} order content. This dataset is fitted using an RBF model MOD_{rbf} (gray line) and a (e.g. 5^{th} order) polynomial model MOD₅ₜₕ (black line). In this illustrative example, both these models fit the data points perfectly and capture the same alignment content. However, the arrows illustrate interpolated regions which differ between the two models due to the different respective bases used; the interpolated regions describing the data between the measured data points as obtained by interpolation using the fitted model parameters of each model.

Methods will be described for mitigating or eliminating either or both of the model content mismatch and/or model interpolation mismatch when using different model strategies in different layers. Throughout the text, model content mismatch will describe the mismatch error described in combination with Figure 4, resulting from different alignment content or more generally metrology content being captured by different models (e.g., because they are each polynomial models of a different order and/or they have a different basis which results in a variation in the content captured should they be used on the same dataset) and model interpolation mismatch will describe the mismatch error described in combination with Figure 5, resulting from an interpolation difference due to using models of different basis (independent of the content captured). Each of model content mismatch and model interpolation mismatch is an example of the more general concept of "model mismatch".

With regard to model content mismatch where the models each capture a different amount of data content, the basic approach may depend on whether a first layer or lower layer is described by the higher order and/or more local model (the higher content capture model which captures the greater amount of metrology content) or the lower order/less local model (the lower content capture model which captures the lesser amount of metrology content) with respect to the model used for a second layer or top layer. As such, a first layer or lower layer in this disclosure comprises a layer exposed before a second layer or top layer and is therefore below the top layer on the substrate.

In the former case, the method essentially comprises forwarding at least some of the additional model content (e.g., higher order content) to use in modeling the second layer. This may be done by forwarding first layer model data, e.g., the fitted model of the first layer (first model), for combining with the fitted model of the second layer (second model) to determine an output model (the complete second layer model). It can be appreciated that this should be done prior to modeling the second layer, such that any common metrology content between the layers can be removed from the second layer metrology data (to obtain corrected second layer metrology data) prior modeling the second layer, thereby preventing double correction.

In the latter case, the method essentially comprises removing any additional metrology content (e.g., higher order content) which cannot be captured by the second model, but was captured by the first layer model, from the second layer metrology data prior to modelling (to obtain corrected second layer metrology data). This additional content may be determined from the first layer model data, e.g. the additional or higher order content of the first layer.

In either case (in most of the embodiments at least), at least some steps of the proposed methods are performed prior to fitting the second model, and therefore the proposed method may be performed within the lithographic apparatus/scanner used to expose the second layer. More specifically, each embodiment comprises removing some first layer metrology content or model content from the second layer metrology data prior to the second layer modeling. This may comprise or be referred to as correcting, or more specifically decorrecting the top layer metrology data.

With regard to model interpolation mismatch, this may be approached by estimating the model interpolation mismatch (e.g., from a difference of the second model fitted to the first layer metrology data or representation thereof and the first layer model fitted to the first layer metrology data) and removing this estimated model interpolation mismatch from the fitted second model. Alternatively, (the content captured by) the first layer model may be removed from the second layer metrology data prior to second model fitting, and the first layer model combined with the second model to determine the an output model (the complete second layer model). The latter approach has the advantage of removing the actual model interpolation mismatch, rather than an estimate.

In embodiments where the second layer metrology data has content removed based on the first layer model or residual data thereof, the method may comprise a step of evaluating the first layer model or residual data on the second layer metrology layout (metrology position, target or mark layout), prior to removing the content (e.g., such that the removal or subtraction can be done per measurement position). In this way, the method can accommodate models in different layers which use different metrology layouts.

A number of specific embodiments will now be described, which illustrate how the aforementioned concepts may be implemented. It can be appreciated that these are only examples and many other implementations are possible within the scope of this disclosure. In each of the accompanying Figures 6 to 10, solid black lines relate to data values (either measured or evaluated from a model), and double compound lines relate to model parameters. The optimization blocks OPT are shown shaded as they relate to neither (rather they determine corrections and/or control actions e.g., in terms of evaluating a cost function).

Figure 6 illustrates a first example of an arrangement for addressing model content mismatch when the lower layer (or first layer) N-1 model MOD_{PHI} is a polynomial model of higher order than the top layer (or second layer) N polynomial model MOD_{PLO}. Note that the models do not need to be polynomial, what matters is that the lower layer model MOD_{PHI} captures more content than the top layer model MOD_{PLO} (i.e., it is a higher content capture model). In this specific example, the lower layer metrology data (first layer metrology data) MEA_{N-1} is subtracted from the top layer metrology data (second layer metrology data) MEA_{N} and only this difference is modelled using the (lower order) top layer polynomial model MOD_{PLO}. The resultant fitted model is then combined with the fitted lower layer model, such that the top layer optimization OPT_{N} is based on an output model comprising a combination of the lower layer model MOD_{PHI} and top layer model MOD_{PLO}.

The lithographic apparatus LA or scanner used to expose the top layer is represented by the dotted line, so as to illustrate the actions which may be performed within and/or by this scanner. To achieve this a first interface I/F1 (a metrology data interface) may receive the lower layer metrology data MEA_{N-1} and a second interface I/F2 (e.g., a fingerprint interface or model coefficient/parameter interface) may receive the fitted lower layer model MOD_{PHI}.

In reality, this embodiment is not very practical as it relies on the metrology data of both layers sharing a common measurement layout. This may not be the case when different modeling strategies are used to model the respective layers.

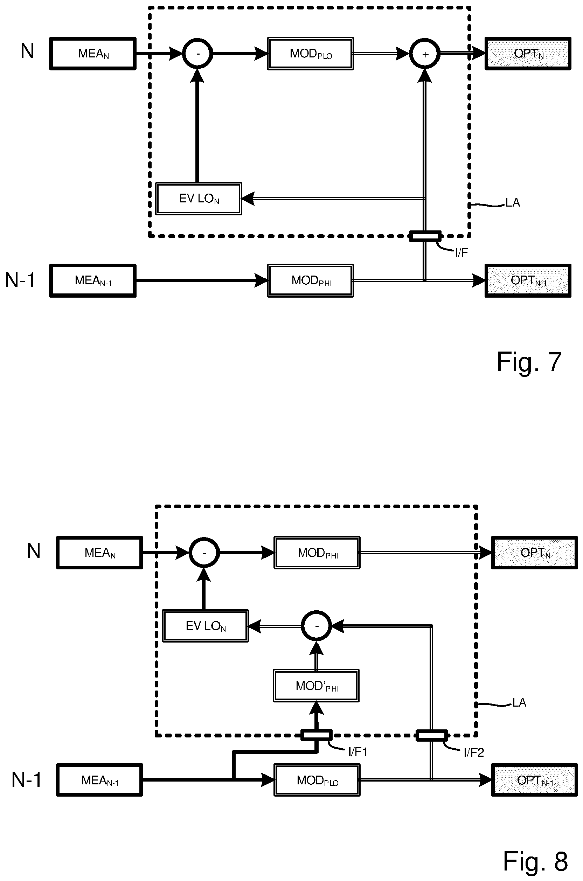

To address situations where different measurement layouts are used in the layers N-1, N, the arrangement illustrated in Figure 6 may be amended to that illustrated in Figure 7. As such, Figure 7 illustrates a second example of an arrangement for addressing model content mismatch when the lower layer N-1 model MOD_{PHI} is a polynomial model of higher order than the top layer N polynomial model MOD_{PLO}. Therefore, instead of directly forwarding the lower layer metrology data MEA_{N-1} for subtraction from the top layer metrology data MEA_{N}, the lower layer fitted model MOD_{PHI} is forwarded via (e.g., fingerprint) interface I/F. This lower layer fitted model MOD_{PHI} is evaluated EV LO_{N} on the measurement layout of the top layer to obtain modeled metrology data values corresponding to the top layer measurement layout. These modeled metrology data values can then be subtracted from the top layer metrology data MEA_{N}, such that the top layer model fitting is performed only on this difference. As before, the resulting fitted model MOD_{PLO} may be combined with the lower layer fitted model MOD_{PHI} to determine an output model for said top layer optimization OPT_{N}. Again, one or both of the models do not need to be polynomial, what matters is that the lower layer model MOD_{PHI} captures more content than the top layer model MOD_{PLO}.

It can be appreciated that this arrangement will also correct for model interpolation mismatch, in addition to model content mismatch, should the models used in the respective layers have different basis. This will be explained later.

Figure 8 illustrates a first example of an arrangement for addressing model content mismatch when the lower layer N-1 model MOD_{PLO} is a polynomial model of lower order than the top layer N polynomial model MOD_{PHI}. Note that the models do not need to be polynomial, what matters is that the lower layer model MOD_{PLO} is a lower content capture model which captures less content than the top layer model MOD_{PHI}. In this embodiment, the top layer model MOD_{PHI} is fitted to a difference of the top layer metrology data MEA_{N} and a high order component of the modeled content of the lower layer, evaluated EV LO_{N} on layout N. This high order component may be captured as the difference of the lower layer fitted model MOD_{PLO} and the same data MEA_{N-1} modeled using the same model MOD'_{PHI} (or another model with similar content capture capability) as that used to model the top layer N. The output model in this example is the fitted top layer model MOD_{PHI}.

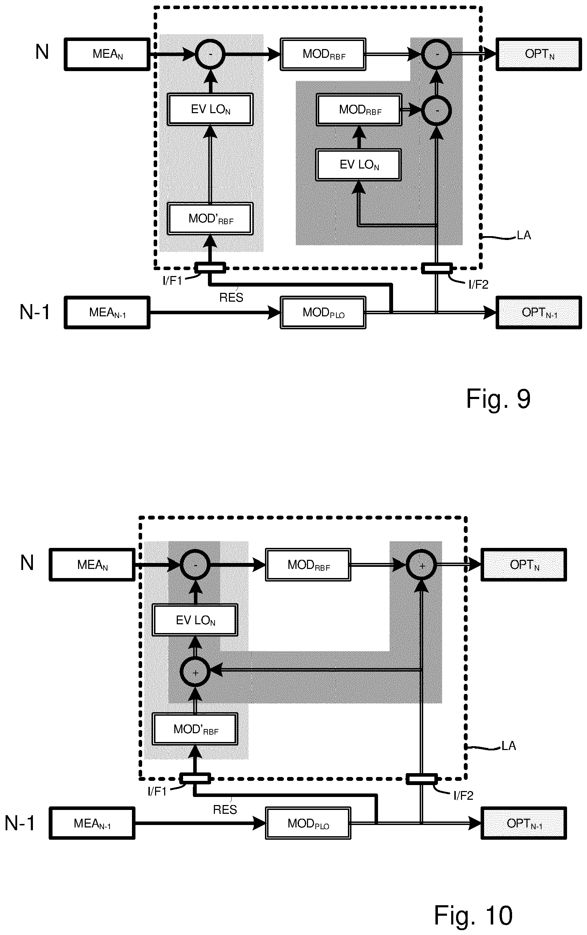

Figure 9 illustrates a first example of an arrangement for addressing model content mismatch when the lower layer N-1 model MOD_{PLO} is a polynomial model which captures less content and has a different basis than the top layer N model MOD_{RBF}. Top layer model MOD_{RBF} in this example is an RBF model.

This arrangement, and the arrangement of Figure 10 to be described below, each comprise two correction mechanisms, either of which may be implemented completely independently, and should therefore be understood to be disclosed independently herein. The lighter shaded flow corrects for model content mismatch and the darker shaded flow addresses the model interpolation mismatch.

Referring specifically to Figure 9, model interpolation mismatch (lower content capture in lower layer) is achieved by modeling (to obtain a residual model) the fit residual data RES, obtained from fitting the lower layer model MOD_{PLO}, using the same model MOD'_{RBF} as the top layer (RBF) model or another model (a different model to the top order model may also be used for this step, the exact choice of model may be optimized in layer setup). This model fitting enables an evaluation EV LO_{N} on the top layer measurement layout, such that the resultant evaluated values can be subtracted from the top layer metrology data MEA_{N}. The fit residual data RES comprise the content not captured by the lower layer model MOD_{PLO}, and this approach also removes this content from the top layer metrology data MEA_{N}, preventing the layer N model from fitting this content thereby mitigating or eliminating the model content mismatch.

The darker shaded flow addresses the model interpolation mismatch by estimating this model interpolation mismatch and subtracting it from the fitted top layer model MOD_{RBF} to obtain an output model for the optimization step OPT_{N}. The model interpolation mismatch estimate may be determined from a difference of the top layer model MOD_{RBF} fitted to evaluated data EV LO_{N} as obtained from an evaluation of the lower layer model MPD_{PLO} on layout N, and the lower layer model MPD_{PLO}.

Figure 10 is a further embodiment, which is generalized in that it can be used for mitigation or elimination of model content mismatch regardless of whether it is the top layer has the higher content capture model, or whether it is the lower layer that has the higher content capture model. Therefore, while the lower layer data MEA_{N-1} is fitted with the lower content capture model with respect to the model fitted to the top layer data MEA_{N} in the specific example shown, these models may be reversed (and may be models of the same basis). In addition to model content mismatch, this embodiment will also mitigate or eliminate model interpolation mismatch.

This embodiment combines the light shaded path flow of Figure 9 and the flow of Figure 7. The light shaded flow operates as has already described with respect to Figure 9 and addresses the model content mismatch when the lower layer model is of a less complex or lower content capture type compared to the top layer model, as illustrated here.

The flow of the darker shaded region corrects the model interpolation mismatch by removing the lower layer model content, as evaluated on the top layer measurement layout, from the top layer metrology data MEA_{N} prior to fitting the top layer model. As such, any (lower order) content that is common between layers N-1 and N will be removed from the metrology data of layer N, prior to fitting, preventing the model of different basis in layer N to fit this content. In addition, the lower layer model is fed forward and combined with the top layer model to determine the output model for optimization OPT_{N}, thereby ensuring that the lower-order content is corrected for in the top layer exposure.

It can be appreciated that this approach mirrors the flow of Figure 7, and therefore that the Figure 10 flow can also mitigate or eliminate model interpolation mismatch, should the models be swapped around with respect to Figure 10 (regardless of whether they are the same or different basis). As such, should the lower layer model have higher content capture capability than the top layer model, then the dark shaded flow will mitigate the model interpolation mismatch. It can be further appreciated that this similarity of Figure 7 and 10 is the reason that the flow of Figure 7 also addresses model interpolation mismatch.

The method disclosed herein enables modeling strategy to be varied layer to layer without incurring (or at least reducing) one or both of model content mismatch and model interpolation mismatch. Other advantages include better outlier detection due to smaller residuals from the top layer modeling. All modeling is performed in-scanner such that no outside control path required. Additionally, because of this, only a single optimization (per layer) is required for correction which loses less information.- less info lost.

In some arrangements, alignment metrology may be performed using a stand-alone or external alignment tool/station, which is external to the lithographic apparatus. This may be done as an alternative to, or supplementary to, alignment metrology within the lithographic apparatus. In such a case, the steps of the methods proposed herein may be performed within such an external alignment tool, within the lithographic apparatus or at a location between the external alignment tool and the lithographic apparatus. Similarly, the method may be implemented within an external (e.g., overlay) metrology tool.

The following clauses describe embodiments of the concepts disclosed herein:
1. A method for modeling metrology data over a substrate area relating to a substrate in a lithographic process, comprising:
   obtaining first layer model data, said first layer model data relating to a first model fitted to first layer metrology data for exposure of a first layer on said substrate;
   obtaining second layer metrology data relating to a second layer on said substrate, said second layer being exposed subsequent to exposure of said first layer;
   subtracting metrology content from said second layer metrology data, said metrology content being obtained from said first layer model data or a component thereof and/or said first layer metrology data to obtain corrected second layer metrology data;
   fitting a second model to said corrected second layer metrology data or a component thereof, said second model being different to said first model; and
   determining an output model from at least said second model, said output model being corrected for a model mismatch resultant from said first model and said second model.
2. A method according to clause 1, wherein said first model and second model differ in the amount of content that they capture from a dataset such that one of said first model and second model is a higher content capture model and the other of said first model and second model is a lower content capture model, and wherein said model mismatch comprises at least model content mismatch.
3. A method according to clause 2, wherein said first model and second model are each polynomial models and said higher content capture model is a polynomial model of higher order than the lower content capture model.
4. A method according to any preceding clause, wherein said metrology content comprises first layer evaluated data, and the method comprises determining said first layer evaluated data from an evaluation of said first model or a related model obtained from said first model on a measurement layout corresponding to a measurement layout of said second layer metrology data to obtain said metrology content.
5. A method according to clause 4, wherein said first layer model data comprises at least residual data describing a difference between said first model and said first layer metrology data, and said evaluation comprises an evaluation of said related model, said related model being a residual model obtained by fitting a model to residual data.
6. A method according to clause 5, wherein said model fitted to the residual data comprises the same model as fitted to obtain said second model.
7. A method according to clause 4, wherein said first layer model data comprises at least said first model and said evaluation comprises an evaluation of said first model or a component of said first model.
8. A method according to clause 7, wherein said evaluation comprises an evaluation of said related model, said related model being obtained as a difference of a higher content capture model fitted to said first layer metrology data and said first model.
9. A method according to clause 8, wherein said higher content capture model captures the same content as said second model.
10. A method according to any of clauses 1 to 7, wherein said first model comprises the higher content capture model and said second model comprises the lower content capture model, and wherein said first layer model data comprises at least said first model; and
   the method comprises combining said second model and said first model to obtain said output model.
11. A method according to clause 10, wherein said step of subtracting metrology content comprises subtracting metrology content from said second layer metrology data which is captured within said first model.
12. A method according to any of clauses 1 to 9, wherein said second model comprises the higher content capture model and said first model comprises the lower content capture model; and
   said step of subtracting metrology content comprises subtracting metrology content from said second layer metrology data which is not captured within said first model.
13. A method according to clause 12, wherein said output model comprises said second model or said second model further corrected for model interpolation mismatch.
14. A method according to any preceding clause, wherein said first model and second model comprise models of a different basis and the model mismatch comprises a model interpolation mismatch.
15. A method according to clause 14, wherein one of said first model and second model comprises a polynomial model and the other of said first model and second model comprises a radial basis function model.
16. A method according to clause 14 or 15, comprising estimating the model interpolation mismatch and removing this estimated model interpolation mismatch from the second model.
17. A method according to clause 16, wherein said first layer model data comprises at least said first model and said estimate is estimated from a difference of the second model fitted to the first layer metrology data or a representation thereof and the first model.
18. A method according to clause 17, wherein said representation comprises an evaluation of said first model on a measurement layout of said second model.
19. A method according to clause 14 or 15, wherein said first layer model data comprises at least said first model and said method comprises:
   subtracting the first model from the second layer metrology data prior to fitting said second model, and
   combining the first model with the second model to obtain said output model.
20. A method according to any preceding clause, comprising performing said method in a lithographic apparatus prior to using said lithographic apparatus to perform an exposure on said substrate in accordance with said output model.
21. A method according to any preceding clause, wherein said first layer metrology data and second layer metrology data each comprise alignment data and said first model and second model each comprise an alignment model.
22. A method for modeling metrology data over a substrate area relating to a substrate in a lithographic process, comprising:
   obtaining first layer model data, said first layer model data relating to a first model fitted to first layer metrology data for exposure of a first layer on said substrate;
   obtaining second layer metrology data relating to a second layer on said substrate, said second layer being exposed subsequent to exposure of said first layer;
   fitting a second model to said corrected second layer metrology data or a component thereof, said first model and second model comprising models of a different basis; and
   estimating a model interpolation mismatch resultant from said different basis and removing this estimated model interpolation mismatch from the second model.
23. A method according to clause 22, wherein one of said first model and second model comprises a polynomial model and the other of said first model and second model comprises a radial basis function model.
24. A method according to clause 23, wherein said first layer model data comprises at least said first model and said estimate is estimated from a difference of the second model fitted to the first layer metrology data or a representation thereof and the first model.
25. A method according to clause 24, wherein said representation comprises an evaluation of said first model on a measurement layout of said second model.
26. A method according to any preceding clause, comprising performing an exposure on said substrate in accordance with said output model.
27. A computer program comprising program instructions operable to perform the method of any of clauses 1 to 25, when run on a suitable apparatus.
28. A non-transient computer program carrier comprising the computer program of clause 27.
29. A processing arrangement comprising:
   the non-transient computer program carrier of clause 28; and
   a processor operable to run the computer program comprised on said non-transient computer program carrier.
30. A lithographic apparatus comprising:
   a patterning device support for supporting a patterning device;
   a substrate support for supporting a substrate;
   a processing arrangement operable to perform said subtracting, fitting, determining, combining,
   evaluation and estimating steps of the method of any of clauses 1 to 25.
   at least one interface for receiving said first layer model data of the method of any of clauses1 to 25; and
31. A lithographic apparatus according to clause 30, further comprising an alignment sensor operable to measure the substrate to obtain at least said second layer metrology data of the method of any of clauses 1 to 25.
32. A lithographic apparatus according to clause 31 or 32, wherein the processing arrangement is further operable to determine corrections for control said patterning device and/or substrate support based on said output model.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.. In that regard, the processed "substrates" may be semiconductor wafers, or they may be other substrates, according to the type of product being manufactured.

Although specific reference may be made in this text to embodiments of the invention in the context of a lithographic apparatus, embodiments of the invention may be used in other apparatus. Embodiments of the invention may form part of a patterning device inspection apparatus, a metrology apparatus, or any apparatus that measures or processes an object such as a wafer (or other substrate) or a mask (or other patterning device). These apparatuses may be generally referred to as lithographic tools. Such a lithographic tool may use vacuum conditions or ambient (non-vacuum) conditions.

In the present document, the terms "radiation" and "beam" are used to encompass all types of radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference may have been made above to the use of embodiments of the invention in the context of optical lithography, it will be appreciated that the invention, where the context allows, is not limited to optical lithography and may be used in other applications, for example imprint lithography.

The terms "optimizing" and "optimization" as used herein refers to or means adjusting an apparatus (e.g., a lithography apparatus), a process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for modeling metrology data over a substrate area relating to a substrate in a lithographic process, comprising:
obtaining first layer model data, said first layer model data relating to a first model fitted to first layer metrology data for exposure of a first layer on said substrate;
obtaining second layer metrology data relating to a second layer on said substrate, said second layer being exposed subsequent to exposure of said first layer;
subtracting metrology content from said second layer metrology data, said metrology content being obtained from said first layer model data or a component thereof and/or said first layer metrology data to obtain corrected second layer metrology data;
fitting a second model to said corrected second layer metrology data or a component thereof, said second model being different to said first model; and
determining an output model from at least said second model, said output model being corrected for a model mismatch resultant from said first model and said second model.

2. A method as claimed in claim 1, wherein said first model and second model differ in the amount of content that they capture from a dataset such that one of said first model and second model is a higher content capture model and the other of said first model and second model is a lower content capture model, and wherein said model mismatch comprises at least model content mismatch.

3. A method as claimed in any preceding claim, wherein said metrology content comprises first layer evaluated data, and the method comprises determining said first layer evaluated data from an evaluation of said first model or a related model obtained from said first model on a measurement layout corresponding to a measurement layout of said second layer metrology data to obtain said metrology content.

4. A method as claimed in claim 3, wherein said first layer model data comprises at least residual data describing a difference between said first model and said first layer metrology data, and said evaluation comprises an evaluation of said related model, said related model being a residual model obtained by fitting a model to residual data.

5. A method as claimed in claim 3, wherein said first layer model data comprises at least said first model and said evaluation comprises an evaluation of said first model or a component of said first model.

6. A method as claimed in claim 5, wherein said evaluation comprises an evaluation of said related model, said related model being obtained as a difference of a higher content capture model fitted to said first layer metrology data and said first model.

7. A method as claimed in any of claims 1 to 5, wherein said first model comprises the higher content capture model and said second model comprises the lower content capture model, and wherein said first layer model data comprises at least said first model; and
the method comprises combining said second model and said first model to obtain said output model.

8. A method as claimed in claim 7, wherein said step of subtracting metrology content comprises subtracting metrology content from said second layer metrology data which is captured within said first model.

9. A method as claimed in any of claims 1 to 6, wherein said second model comprises the higher content capture model and said first model comprises the lower content capture model; and
said step of subtracting metrology content comprises subtracting metrology content from said second layer metrology data which is not captured within said first model.

10. A method as claimed in claim 9, wherein said output model comprises said second model or said second model further corrected for model interpolation mismatch.

11. A method as claimed in any preceding claim, wherein said first model and second model comprise models of a different basis and the model mismatch comprises a model interpolation mismatch.

12. A method as claimed in claim 11, comprising estimating the model interpolation mismatch and removing this estimated model interpolation mismatch from the second model.

13. A method as claimed in claim 12, wherein said first layer model data comprises at least said first model and said estimate is estimated from a difference of the second model fitted to the first layer metrology data or a representation thereof and the first model, wherein said representation comprises an evaluation of said first model on a measurement layout of said second model.

14. A method as claimed in claim 11, wherein said first layer model data comprises at least said first model and said method comprises:
subtracting the first model from the second layer metrology data prior to fitting said second model, and
combining the first model with the second model to obtain said output model.

15. A computer program comprising program instructions operable to perform the method of any of claims 1 to 14, when run on a suitable apparatus.
